(19) **Europäisches Patentamt**

**European Patent Office**

**Office européen des brevets**

(11) Publication number: **0 507 502 A2**

# (12) EUROPEAN PATENT APPLICATION

(21) Application number: **92302635.5**

(22) Date of filing: **26.03.92**

(51) Int. Cl.5: **H03K 17/06**

(30) Priority: **03.04.91 US 679702**

(43) Date of publication of application:
**07.10.92 Bulletin 92/41**

(84) Designated Contracting States:
**DE FR GB**

(71) Applicant: **NATIONAL SEMICONDUCTOR CORPORATION**
**2900 Semiconductor Drive M.S. 16-135**
**Santa Clara California 95052(US)**

(72) Inventor: **Sandhu, Bal**
**3641 Pintail Terrace**
**Fremont, California 94536(US)**
Inventor: **Leung, Frederick K.**
**11522 Country Spring Court**
**Cupertino, California 95014(US)**

(74) Representative: **Horton, Andrew Robert Grant et al**
**BOWLES HORTON Felden House Dower Mews High Street**
**Berkhamsted Hertfordshire HP4 2BL(GB)**

(54) **High voltage charge pumps.**

(57) A charge pump circuit for use in electrically erasable programmed read-only memories is described herein. The charge pump uses a single clock signal, a voltage feedback arrangement to allow a DC voltage to pass a DC voltage, and a plurality of transistors, each transistor being coupled in series with each grounded-gate transistor, eliminating reverse-breakdown voltage loads on the grounded gate transistors.

FIG. 2

EP 0 507 502 A2

The present invention relates to high voltage charge pumps, particularly for use in providing voltage levels necessary to program electrically erasable programmable read-only memories (EEPROMs).

Circuits for high voltage charge pumps are known. One example, which discloses features set forth in the precharacterising parts of the independent claims, is particularly described hereinafter. As will become apparent from the subsequent description, the present invention aims to improve the existing charge pumps in a variety of ways. However, the present invention is not limited to configurations corresponding to that specific known circuit.

One aspect of the present invention in its preferred form concerns an improved technique for controlling a pass gate for transferring an input voltage to an output and in particular to reduce fluctuations in the control voltage.

Another aspect of the present invention in a specific embodiment concerns the disposition of a depletion transistor in series with any transistor that may have a grounded gate, the depletion transistor having its gate connected, for example to the appropriate supply rail, such that this transistor is always conductive. This circuit disposition substantially increases the breakdown voltage (drain to source) for the grounded gate transistor and permits a much higher gate voltage to pass the programming voltage.

A further aspect of the present invention in a preferred embodiment concerns the avoidance of skew between a clock signal and its nominal inverse.

According to the invention, a charge pump comprises a pass gate coupled between an input voltage supply node and an output voltage supply node, a control node for the pass gate, means for enabling the control node to control the pass gate, means for coupling a clock signal voltage to the control node, and voltage stabilizing means connected to the control node to maintain the voltage at the control node in the absence of the clock signal.

The means for enabling the control node may comprise a first switch means responsive to a programming signal to couple the control node to a first reference voltage and wherein second switch means are responsive to the inverse of the programming signal to couple the control node to a second reference voltage such as ground whereby to disable the control node.

The means for coupling the clock voltage comprises a third switch means, preferably arranged to provide regenerative feedback which increases the voltage at the control node.

The voltage stabilizing means may comprise a capacitor.

A fourth switch means may be provided for coupling the output voltage supply node to a reference voltage in response to the inverse of the programming signal.

Any one or more of the first, second and fourth switch means may be disposed in series with a respective transistor which is always conductive irrespective of the states of the clock and programming signals.

Brief Description of the Drawings

Figure 1 is a circuit diagram of a known charge pump; and

Figure 2 is a circuit diagram of one embodiment of the present invention.

Detailed Description

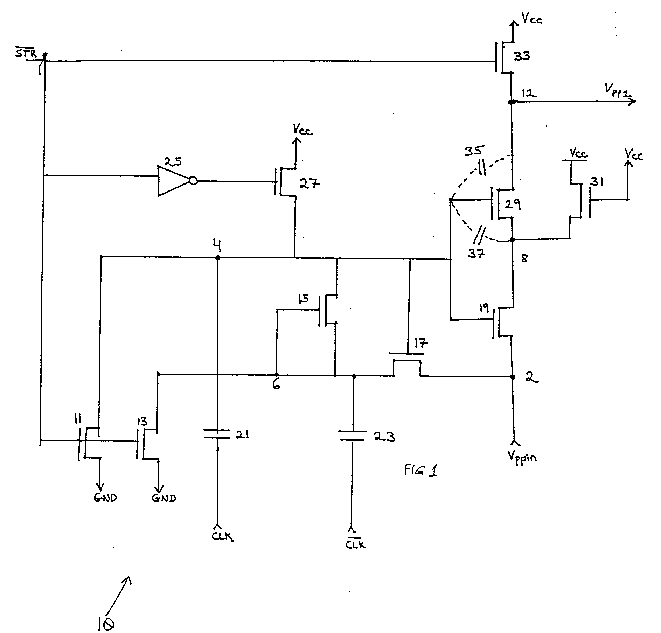

One example of a known charge pump 10 (illustrated for the sake of example only) is shown in Figure 1. The purpose of the circuit is to pass a voltage Vppin, which appears on an external node 2, to an internal node 12 which is coupled to the memory cell being programmed. Ideally, there should be no voltage loss between Vppin and Vpp1, the output voltage at node 12.

Voltage is transferred by way of pass gates constituted by transistors 19 and 29, which are controlled by a voltage on a pumped control node 4. The node 8 between the transistors is connected to the supply rail (Vcc) by way of a transistor 31 (configured as a diode).

When the EEPROM is being programmed, a signal STR* (the inverse of a programming signal STR) goes low. The gates of transistors 11, 13 and 33 all receive this signal, turning the transistors off. Simultaneously, the signal STR* is applied to an inverter 25, the resultant signal being applied to the gate of a transistor 27. Transistor 27 turns on, applying a voltage of Vcc - Vt (Vt being the voltage drop across a given transistor) to a node 4.

A clock signal CLK is applied by way of a capacitor 21 to the node 4 and the inverse (CLK*) of the clock signal is applied to a node 6 which is connected by way of a transistor 15 (configured as a diode) to the node 4 and by way of a transistor 17 to the node 2, the gate of transistor 17 being connected to the node 4.

The clock signal CLK now goes to a high voltage level, and node 4 now reaches approximately (Vcc - Vt) + (Vclk . X) volts, where Vclk is the clock amplitude swing and X is a capacitive divider ratio calculated as $X = Cd/Cd + Cs$, where Cd is the value of the pump capacitor(s) 21 and 23 and Cs is the total junction capacitance on node 4. Typically logic levels of zero volts for a binary 0 and 5 volts for binary 1 are used. As CLK is high, CLK* is low. At this time, transistors 17, 19 and 29 are all on, as their gates receive a high voltage from node 4. As the gate of transistor 15 and the drain of transistor 15 are coupled to CLK*, transistor 15 turns off. With transistor 17 conducting, node 6 climbs in voltage to V4 - Vt (the voltage at node 4 less the voltage drop across one transistor) also charging capacitor 23. Node 6 will be limited to some fraction of Vppin, for example about 7-8 volts.

When CLK goes low and CLK* goes high, transistor 15 turns on, the voltage on node 6 rises, and the voltage on node 4 begins to drop. However, the charge on capacitor 21 is supported by the current through transistor 15 as the voltage on node 6 rises due to CLK* going high, and the voltage on node 4 drops (in this example) to about 12 volts. When the CLK and CLK* signals again reverse themselves, the voltage on node 4 climbs again.

After (typically) about a microsecond, the circuit stabilizes, with node 4 varying in voltage between 15 and 17 volts. Ideally, the voltage on node 4 coupled to the gates of transistors 29 and 19 should pass the Vppin voltage from node 2 to node 12.

The type of charge pump just described has several deficiencies. Transistors 11, 13 and 33 each have their gates grounded during programming. This limits the total voltage which can be applied to their drain without causing reverse breakdown of the transistor. Additionally, even if breakdown does not occur, leakage currents to ground can result, causing a loss of voltage from Vpp1. For the circuit shown in Figure 1, a maximum of roughly 16.5 volts can be applied to the drain of transistors 11 and 13 before the breakdown occurs. In turn, this requirement limits the maximum voltage that can be applied to the gate of transistor 29.

Node 4, after the circuit reaches equilibrium, alternates between 15 and 17 volts. This results in some AC coupling between node 4 and node 8 and node 4 and node 12 (by way of capacitances 37 and 35 respectively) as Vpp1 approaches Vppin. The coupling reduces the amount of charge that can be passed to Vpp1.

The charge pump also uses both the clock signals CLK and its nominal inverse CLK* at separate inputs. Any skew between CLK and CLK* reduces the efficiency of the charge pump, because node 4 discharges to a lower level than optimum.

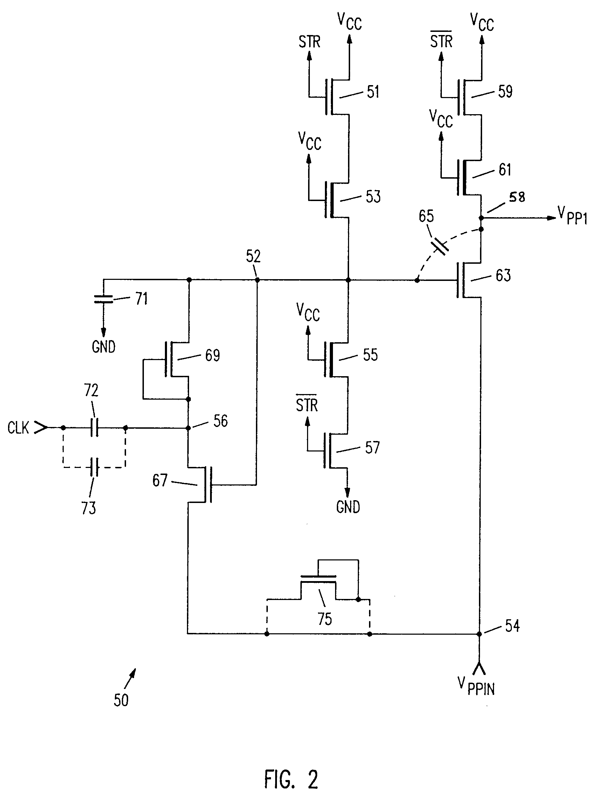

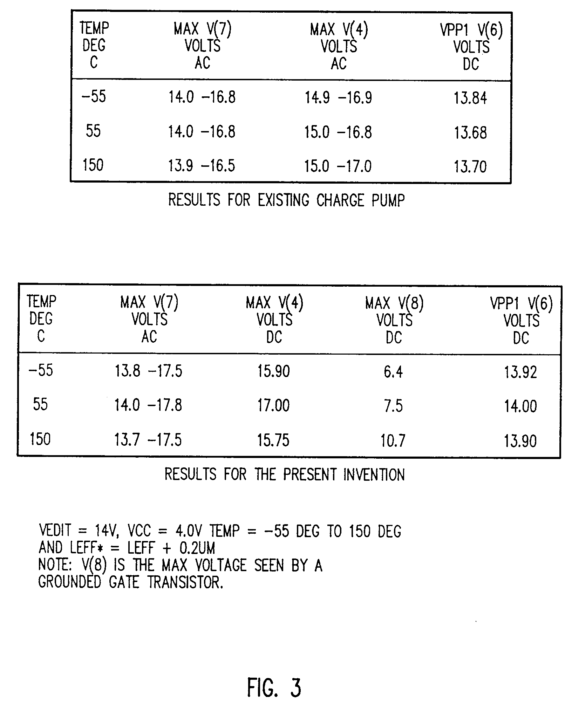

Figure 2 illustrates a preferred embodiment of the present invention.

In Figure 2, an input node 54 for the input voltage Vppin is coupled by way of a pass gate constituted by transistor 63 to a node 58, which is to provide the output voltage Vpp1. The node 58 is coupled to the supply rail (Vcc) by way of a transistor 59, of which the gate is controlled by the inverse (STR*) of the programming signal (STR). An additional depletion channel transistor 61, of which the gate is connected to the supply rail is disposed in series between the transistor 59 and node 58. The gate of transistor 63 constitutes a control node 52 (corresponding to the node 4 of Figure 1). Node 52 is coupled to the supply rail by way of transistor 51, controlled by programming signal STR and to ground by way of transistor 57, controlled by the inverse (STR*) of the programming signal. Two additional transistors 53 and 55, each of which has its gate connected to the supply rail, are in series between the transistor 51 and the node 52 and between the transistor 57 and the node 52 respectively.

A clock signal CLK is applied through a capacitor 72 to a node 56, which is connected by way of a transistor 69 (configured as a diode) to the node 52 and by way of a transistor 67 to the node 54, the gate of the transistor 67 being connected to the node 4. Transistor (or diode) 69 and transistor 67 generally correspond to the transistor (or diode) 15 and the transistor 17 in Figure 1. The inverse (CLK*) of the clock signal is not required. The node 52 is also connected to ground by a stabilising capacitor 71.

During programming of the EEPROM, STR goes high and STR* goes low. Transistors 59 and 57 turn off and transistor 51 turns on. As the gates of 53, 61, and 55 are coupled to Vcc, these transistors are always on. Thus, once STR goes high, node 52 charges up to Vcc - Vt. When STR* is high, the pump is not used for programming, and the charge on node 52 is drained through transistors 55 and 57 to ground, which in turn shuts off transistor 63.

Given that STR is high and STR* is low, the first high CLK pulse begins the charging process. When CLK goes high, transistor 69, which functions as a forward biased diode, turns on. Node 52, which was at Vcc - Vt, now rises to Vcc - 2 Vt + Vclk.X, where X is Cd/(Cd + Cs), Cd being the capacitance of the pump capacitor 72 and Cs being the total capacitance on the node 4. This voltage feeds back to transistor 67, turning it on, thereby still further increasing the voltages on nodes 56 and 52.

When the clock signal CLK goes low, capacitor 71 maintains the voltage on node 52. Transistor 69 becomes reversed biased when the clock goes from high to low. This isolates the voltage on node 52.

Successive clock pulses result in node 52 reaching and holding a voltage between 15 and 17 volts, depending on the temperature and Vcc. That voltage can be held fairly steady by capacitor 71. In addition, the increase in voltage on node 52 occurs in a much more linear fashion than the known art.

As shown in Figure 2, each transistor having a grounded gate (transistors 51, 57 and 59) is coupled in series with a transistor (53, 55 and 61 respectively) with its gate coupled to the supply rail Vcc, so that the depletion transistor is always conducting. This effectively increases the breakdown voltage from drain to source from 16.5 volts to 22 volts for transistors with grounded gates, eliminating the need for 'edgeless' transistors and allowing a higher gate voltage to pass the programming voltage.

Several modifications to the present invention are possible. By coupling transistor 75 into the circuit, another voltage drop Vt can be obtained between nodes 54 and 56. Also, a second clock coupling capacitor 73 could be fabricated, improving the pump's efficiency.

**Claims**

1. A charge pump comprising a pass gate (63) coupled between an input voltage supply node (54) and an output voltage supply node (58), a control node (52) for the pass gate, means (51, 57) for enabling the control node to control the pass gate, means (67, 69, 72) for coupling a clock signal voltage to the control node, and voltage stabilizing means (71) connected to the control node to maintain the voltage at the control node in the absence of the clock signal.

2. A charge pump according to claim 1 wherein the means for enabling the control node comprises a first switch means (51) responsive to a programming signal (STR) to couple the control node to a first reference voltage and wherein second switch means (57) are responsive to the inverse of the programming signal to couple the control node (4) to a second reference voltage such as ground whereby to disable the control node.

3. A charge pump according to claim 1 or claim 2 wherein the means for coupling the clock voltage comprises a third switch means (67, 69).

4. A charge pump according to any foregoing claim wherein the voltage stabilizing means (71) comprises a capacitor.

5. A charge pump according to claim 2 or claims 2-4, further comprising a fourth switch means (59) for coupling the output voltage supply node to a reference voltage in response to the inverse of the programming signal.

6. A charge pump according to claim 2 or claim 5 wherein any one of the first, second and fourth switch means is disposed in series with a transistor which is always conductive irrespective of the states of the clock and programming signals.

7. A charge pump according to claims 1 to 5 wherein the first switch means comprises a first transistor (51) and a second transistor (53), a gate of the first transistor being coupled to receive the programming signal, the drain of the first transistor being coupled to a source of the second transistor, a gate of the second transistor being coupled to the reference voltage, and a drain of the second transistor being coupled to the control node.

8. A charge pump according to claim 7 wherein the second switch means comprises a third transistor (55) and a fourth transistor (57), a source of the third transistor being coupled to the control node (52), a gate of the third transistor being coupled to the first reference voltage, a drain of the third transistor being coupled to a source of the fourth transistor, a gate of the fourth transistor being coupled to the inverse (STR*) of the programming signal, and a drain of the fourth transistor being coupled to a ground voltage.

9. A charge pump according to claim 8 wherein the third switch means comprises a diode means (69) coupled between the control node (52) and a clock input node (56), and a fifth transistor (67), a gate of the fifth transistor being coupled to the control node, a drain of the fifth transistor being coupled to the clock input node, and a source of the fifth transistor being coupled to the voltage supply node (54), there being an input capacitor (72) for coupling the clock signal to the clock input node.

10. A charge pump according to claim 9 wherein the fourth switch means comprises a sixth and seventh transistor, a source of the sixth transistor being coupled to the second voltage, a gate of the sixth transistor (59) being coupled to the inverse (STR*) of the programming signal, a drain of the sixth transistor being coupled to a source of the seventh transistor (61), a gate of the seventh transistor (61) being coupled to the first reference voltage and a drain of the seventh transistor being coupled to the output voltage supply node.

11. A method for transferring a first voltage on a first input node (54) to a first output node (58), the method comprising the steps of:

switching a second voltage (Vcc) to a second node (52) in response to a first signal (STR);

switching the second node (52) to a ground voltage in response to an inverse of the first signal;

switching a clock voltage to the second node (52) when a clock signal is present and maintaining the clock voltage on the second node when the clock signal is not present;

switching the first output node (58) to the second voltage in response to the inverse of the first signal; and

switching the first voltage on the first input node (54) to the first output node (58) in response to the first signal and the voltage on the second node (52).

FIG 1

FIG. 2

| TEMP DEG C | MAX V(7) VOLTS AC | MAX V(4) VOLTS AC | VPP1 V(6) VOLTS DC |
|---|---|---|---|
| −55 | 14.0 −16.8 | 14.9 −16.9 | 13.84 |
| 55 | 14.0 −16.8 | 15.0 −16.8 | 13.68 |
| 150 | 13.9 −16.5 | 15.0 −17.0 | 13.70 |

RESULTS FOR EXISTING CHARGE PUMP

| TEMP DEG C | MAX V(7) VOLTS AC | MAX V(4) VOLTS DC | MAX V(8) VOLTS DC | VPP1 V(6) VOLTS DC |
|---|---|---|---|---|
| −55 | 13.8 −17.5 | 15.90 | 6.4 | 13.92 |
| 55 | 14.0 −17.8 | 17.00 | 7.5 | 14.00 |
| 150 | 13.7 −17.5 | 15.75 | 10.7 | 13.90 |

RESULTS FOR THE PRESENT INVENTION

VEDIT = 14V, VCC = 4.0V TEMP = −55 DEG TO 150 DEG
AND LEFF* = LEFF + 0.2UM
NOTE: V(8) IS THE MAX VOLTAGE SEEN BY A
GROUNDED GATE TRANSISTOR.

FIG. 3